# EUROPÄISCHE PATENTANMELDUNG

(11) **EP 2 544 372 A1**
(43) Veröffentlichungstag der Anmeldung: **09.01.2013**
(21) Anmeldenummer: 12174992.3
(22) Anmeldetag: 04.07.2012
(51) Int. Cl.: H03K 17/96

(54) **Verfahren zum Betreiben eines piezokeramischen Sensors und Schaltung zur Durchführung des Verfahrens**

(30) Priorität: 05.07.2011 DE 102011078694
(71) Anmelder: E.G.O. ELEKTRO-GERÄTEBAU GmbH, 75038 Oberderdingen (DE)
(72) Erfinder: Fluhrer, Henry, 75015 Bretten (DE); Hörner, Uwe, 75031 Eppingen (DE)
(74) Vertreter: Patentanwälte Ruff, Wilhelm, Beier, Dauster & Partner

(57) **Zusammenfassung**

Bei einem Verfahren zum Betreiben eines piezokeramischen Sensors (1) mit einer Auswerteelektrode (1a) wird ein von dem piezokeramischen Sensor an der Auswerteelektrode erzeugtes elektrisches Signal (Us) zum Bestimmen eines Betätigungszustandes des piezokeramischen Sensors ausgewertet. Die Auswerteelektrode wird mit einem vorgegebenen Referenzpotential (Uref) während wiederkehrender Zeitabschnitte (Za) beaufschlagt.

## Beschreibung

### Anwendungsgebiet und Stand der Technik

Die Erfindung betrifft ein Verfahren zum Betreiben eines piezokeramischen Sensors und eine Schaltung zur Durchführung des Verfahrens.

Piezokeramische Sensoren geben eine Spannung aus, die von einer Druckbeaufschlagung des Sensors abhängig ist. Mittels piezokeramischer Sensoren kann beispielsweise eine Tastenfunktion implementiert werden.

Die vom piezokeramischen Sensor erzeugte Spannung wird üblicherweise mittels eines Impedanzwandlers aufbereitet, da der piezokeramische Sensor nicht dazu geeignet ist, größere Lasten zu treiben. Der sehr hochohmige Eingang des Impedanzwandlers hat jedoch zur Folge, dass eingekoppelte Störimpulse die Auswertung langfristig verfälschen. Daher muss sichergestellt werden, dass derartige Störimpulse wirkungsvoll unterdrückt werden. Gleichzeitig muss gewährleistet sein, dass eine Betätigung des piezokeramischen Sensors über eine längere Zeitdauer, beispielsweise mehrere Sekunden, trotz der Störunterunterdrückung zuverlässig detektierbar ist.

Die WO 01/22587 A1 offenbart ein Verfahren und eine zugehörige Schaltung, bei denen in einem nicht betätigten Zustand eine Auswerteelektrode eines piezokeramischen Sensors mittels eines vergleichsweise niederohmigen Widerstands mit Masse verbunden ist, um eine hohe Störunterdrückung zu gewährleisten. Sobald eine Betätigung des piezokeramischen Sensors detektiert wird, wird die Auswerteelektrode mittels eines hochohmigen Widerstands anstelle des niederohmigen Widerstands mit Masse verbunden, um die Auswerteempfindlichkeit zu erhöhen und so beispielsweise auch länger andauernde Betätigungen zuverlässig detektieren zu können.

### Aufgabe und Lösung

Der Erfindung liegt die Aufgabe zugrunde, ein Verfahren zum Betreiben eines piezokeramischen Sensors und eine Schaltung zur Durchführung des Verfahrens zur Verfügung zu stellen, die eine zuverlässige Auswertung des piezokeramischen Sensors ermöglichen.

Die Erfindung löst diese Aufgabe durch ein Verfahren nach Anspruch 1 und eine Schaltung nach Anspruch 6.

Bei dem Verfahren zum Betreiben eines piezokeramischen Sensors mit einer Auswerteelektrode wird herkömmlich ein von dem piezokeramischen Sensor an der Auswerteelektrode erzeugtes elektrisches Signal zum Bestimmen eines Betätigungszustandes des piezokeramischen Sensors ausgewertet. Insoweit sei auch auf die einschlägige Fachliteratur verwiesen. Die Auswerteelektrode wird mit einem vorgegebenen (Referenz-)Potential, beispielsweise dem Massepotential oder einem Potential, das in etwa der Hälfte einer Versorgungsspannung einer zugehörigen Auswerteschaltung entspricht, während periodisch oder nicht periodisch wiederkehrender Zeitabschnitte mit identischer oder variabler Dauer beaufschlagt, insbesondere um die Auswerteelektrode während dieser Zeitabschnitte mit dem (Referenz-)Potential zu referenzieren. Außerhalb der wiederkehrenden Zeitabschnitte wird die Auswerteelektrode nicht mit dem (Referenz-)Potential beaufschlagt. Eine dauerhafte Kopplung der Auswerteelektrode mit dem (Referenz-)Potential, beispielsweise über Kopplungswiderstände wie in der WO 01/22587 A1, findet nicht statt. Aufgrund des Beaufschlagens mit dem (Referenz-)Potential kann beispielsweise ein schleichender Ladungsverlust in dem als Kondensator wirkenden piezokeramischen Sensor aufgrund von Leckströmen ausgeglichen werden, insbesondere während der Sensor nicht betätigt ist. Im Gegensatz zur WO 01/22587 A1 erfolgt kein dauerhaftes Entladen des Sensors über veränderliche Widerstände, sondern es wird typisch während der Zeitabschnitte Ladung hinzugefügt und somit die Spannung am Sensor aufrechterhalten.

In einer Weiterbildung weist ein jeweiliger Zeitabschnitt eine Zeitabschnittsdauer auf und aufeinanderfolgende Zeitabschnitte sind um eine Zeitabschnittswiederholdauer zeitlich beabstandet, wobei die Zeitabschnittsdauer konstant oder variabel gewählt wird und/oder die Zeitabschnittswiederholdauer konstant oder variabel gewählt wird.

In einer Weiterbildung werden weiter folgende Schritte durchgeführt: Messen eines Spannungsverlaufs an der Auswerteelektrode, insbesondere während die Auswerteelektrode nicht mit dem Referenzpotential beaufschlagt ist, Auswerten des gemessenen Spannungsverlaufs, um gegebenenfalls einen Störimpuls zu ermitteln, wobei zur Auswertung beispielsweise eine Anstiegsgeschwindigkeit des Spannungsverlaufs, eine Amplitude bzw. Signalhöhe des Spannungsverlaufs und/oder eine Impulsdauer des Spannungsverlaufs berücksichtigt werden kann, falls dieser einen im Wesentlichen impulsförmigen Verlauf aufweist, und Beaufschlagen der Auswerteelektrode mit dem Referenzpotential für eine Zeitabschnittsdauer, die insbesondere größer als eine mittlere Zeitabschnittsdauer gewählt ist, wenn der Störimpuls ermittelt worden ist, um die Auswirkungen des Störimpulses wirksam zu unterdrücken. Zur Auswertung des gemessenen Spannungsverlaufs kann dieser mit dem Spannungsverlauf einer typischen Betätigung verglichen werden, beispielsweise hinsichtlich einer Anstiegsgeschwindigkeit, einer Anstiegsdauer, einer Gesamtdauer etc., wobei jeder Spannungsverlauf, der nicht dem Verlauf der typischen Betätigung entspricht, als Störimpuls klassifiziert wird.

In einer Weiterbildung werden weiter folgende Schritte durchgeführt: Messen eines Spannungsverlaufs an der Auswerteelektrode und Auswerten des gemessenen Spannungsverlaufs, um gegebenenfalls eine Betätigung des piezokeramischen Sensors zu ermitteln, wobei die Zeitabschnittswiederholdauer für den Fall der gegebenenfalls ermittelten Betätigung mindestens so groß wie eine ermittelte Betätigungsdauer gewählt wird, so dass die Auswerteelektrode während der gegebenenfalls ermittelten Betätigung nicht mit dem Referenzpotential beaufschlagt wird.

Alternativ werden folgende Schritte durchgeführt: Wählen einer konstanten Zeitabschnittswiederholdauer, d.h. die Zeitabschnitte werden periodisch wiederholt, Messen eines Spannungsverlaufs an der Auswerteelektrode, Integrieren des gemessenen Spannungsverlaufs und Auswerten des integrierten Spannungsverlaufs zum Bestimmen eines Betätigungszustands des piezokeramischen Sensors. Für diesen Fall erfolgt das Referenzieren auch bei betätigtem Sensor.

Die Schaltung zur Durchführung des oben genannten Verfahrens weist auf: Mittel zum Beaufschlagen der Auswerteelektrode des piezokeramischen Sensors mit dem vorgegebenen Referenzpotential während der wiederkehrenden Zeitabschnitte.

In einer Weiterbildung weist die Schaltung eine Referenzspannungsquelle zum Erzeugen des Referenzpotentials bzw. der Referenzspannung auf.

In einer Weiterbildung ist das Referenzpotential ein Massepotential oder ein Potential zwischen dem Massepotential und einer Versorgungsspannung der Schaltung, beispielsweise 2,5V, wenn die Versorgungsspannung 5V beträgt.

In einer Weiterbildung weist die Schaltung auf: ein ansteuerbares Schaltmittel, das mit einem Anschluss mit dem Referenzpotential beaufschlagt ist, das mit einem anderen Anschluss mit der Auswerteelektrode verbunden ist und das die Auswerteelektrode in Abhängigkeit von einem Ansteuersignal mit dem Referenzpotential verbindet oder von diesem trennt, und eine Steuereinrichtung zur Erzeugung des Ansteuersignals.

In einer Weiterbildung weist die Schaltung auf: einen Impedanzwandler mit einem hochohmigen Eingang und einem niederohmigen Ausgang, wobei der Impedanzwandler das an der Auswerteelektrode erzeugte elektrisches Signal an seinem Eingang empfängt und an seinem Ausgang niederohmig ausgibt, und eine Auswerteeinrichtung, die das am Ausgang des Impedanzwandlers ausgegebene Signal auswertet.

In einer Weiterbildung umfasst die Schaltung einen Mikroprozessor, wobei die Referenzspannungsquelle und/oder der Impedanzwandler in den Mikroprozessor integriert ist/sind.

Vorteilhafte Ausführungsformen der Erfindung sind in den Zeichnungen schematisch dargestellt und werden nachfolgend beschrieben. Hierbei zeigt/zeigen:

### Kurzbeschreibung der Zeichnungen

- Fig. 1: eine erfindungsgemäße Schaltung zum Betreiben eines piezokeramischen Sensors,
- Fig. 2: einen zeitlichen Verlauf von Signalen der in Fig. 1 gezeigten Schaltung gemäß einer ersten Ausführungsform,
- Fig. 3: einen zeitlichen Verlauf von Signalen der in Fig. 1 gezeigten Schaltung gemäß einer weiteren Ausführungsform und
- Fig. 4: einen zeitlichen Verlauf von Signalen der in Fig. 1 gezeigten Schaltung für den Fall eines Störimpulses.

### Detaillierte Beschreibung der Zeichnungen

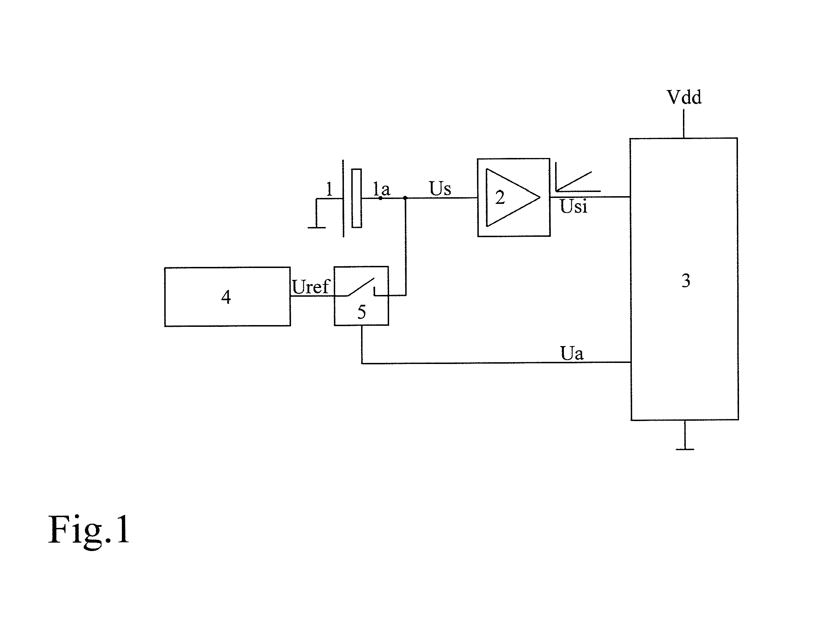

Fig. 1 zeigt eine erfindungsgemäße Schaltung zum Betreiben eines piezokeramischen Sensors 1 mit einer Auswerteelektrode 1a, wobei im Betrieb der Schaltung ein von dem piezokeramischen Sensor 1 an der Auswerteelektrode 1a erzeugtes elektrisches Signal Us zum Bestimmen eines Betätigungszustandes, d.h. gedrückt bzw. nicht gedrückt, des piezokeramischen Sensors 1 ausgewertet wird.

Die Schaltung umfasst einen Impedanzwandler 2 mit einem hochohmigen Eingang und einem niederohmigen Ausgang, wobei der Impedanzwandler 2 das an der Auswerteelektrode 1a erzeugte elektrische Signal Us an seinem Eingang empfängt und an seinem Ausgang impedanzgewandelt als Signal Usi ausgibt.

Eine Auswerteeinrichtung 3, beispielsweise in Form eines Mikroprozessors mit einem analogen Eingang, wertet das am Ausgang des Impedanzwandlers 2 ausgegebene Signal Usi zum Bestimmen des Betätigungszustandes des piezokeramischen Sensors 1 aus.

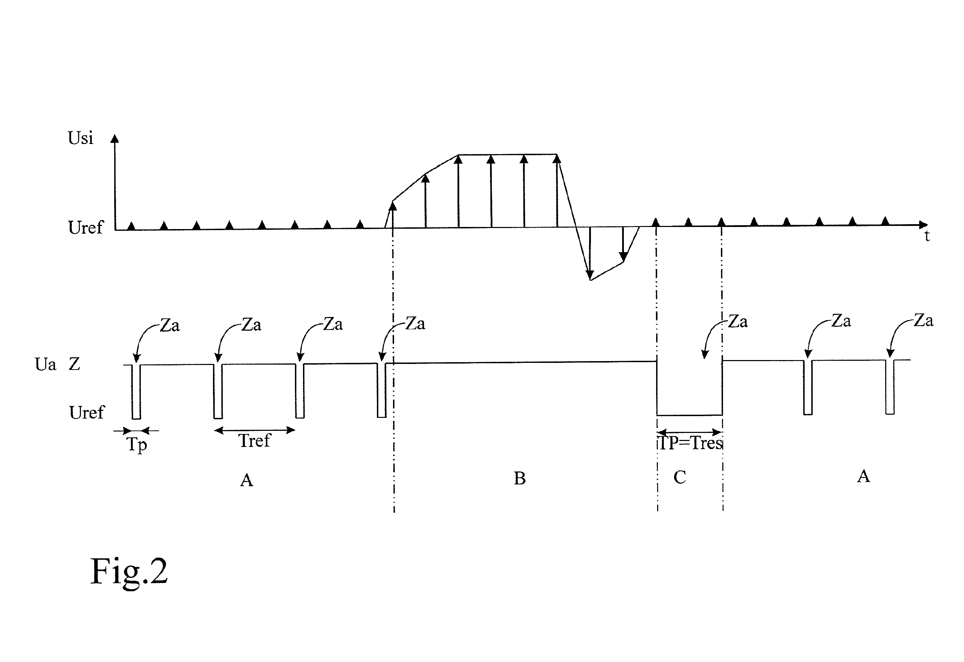

Zur Störunterdrückung sind Mittel zum Beaufschlagen der Auswerteelektrode 1a mit einem vorgegebenen Referenzpotential bzw. einer vorgegebenen Referenzspannung Uref während wiederkehrender Zeitabschnitte (siehe Figuren 2 bis 4 "Za") vorgesehen. Diese Mittel umfassen eine Referenzspannungsquelle 4 zum Erzeugen des Referenzpotentials bzw. der Referenzspannung Uref, beispielsweise Vdd/2, wobei Vdd eine Versorgungsspannung der Schaltung darstellt, ein ansteuerbares Schaltmittel 5, das mit einem Anschluss mit dem Referenzpotential bzw. der Referenzspannung Uref beaufschlagt ist, das mit einem anderen Anschluss mit der Auswerteelektrode 1a verbunden ist und das die Auswerteelektrode 1a in Abhängigkeit von einem Ansteuersignal Ua mit dem Referenzpotential bzw. der Referenzspannung Uref verbindet oder von diesem/dieser trennt, und eine Steuereinrichtung 3 zur Erzeugung des Ansteuersignals Ua. Die Steuereinrichtung und die Auswerteeinrichtung können gemeinsam in einen Mikroprozessor 3 integriert sein, der sowohl die Steuer- als auch die Auswertefunktionen verwirklicht.

Fig. 2 zeigt einen zeitlichen Verlauf von Signalen der in Fig. 1 gezeigten Schaltung gemäß einer ersten Ausführungsform.

Die vom Impedanzwandler 2 ausgegebene Spannung Usi wird periodisch mit einer Abtastrate durch die Auswerteeinrichtung bzw. einen A/D-Wandler des Mikroprozessors 3 abgetastet, was durch Pfeile symbolisiert ist.

In einem Zeitraum "A" ist die abgetastete Spannung Usi konstant und entspricht einem nicht betätigten Zustand. Für diesen Fall wird das Ansteuersignal Ua derart erzeugt, dass die Auswerteelektrode 1a mit dem Referenzpotential Uref während wiederkehrender Zeitabschnitte Za beaufschlagt wird (Signalzustand des Ansteuersignals Ua ist für diesen Fall "Uref"). Außerhalb der Zeitabschnitte Za ist die Schaltstellung des Schaltmittels 5 aufgrund des Zustands des Steuersignals Ua derart (Signalzustand des Ansteuersignals Ua ist für diesen Fall "Z"), dass die Auswerteelektrode 1a nicht mit dem Referenzpotential Uref beaufschlagt ist. Die Zeitabschnitte Za wiederholen sich im Zeitraum "A" periodisch mit einer Zeitabschnittswiederholdauer bzw. Periodendauer Tref und weisen eine konstante Zeitabschnittsdauer Tp auf.

In einem Zeitraum "B" weist die abgetastete Spannung Usi einen Verlauf auf, der einer typischen Tastenbetätigung entspricht, d.h. die abgetastete Spannung nimmt zunächst mit einer charakteristischen Steigung zu, bleibt dann für eine Betätigungsdauer in etwa konstant und nimmt dann beim Loslassen der Sensortaste 1 mit einem leichten Unterschwinger wieder bis auf den konstanten Wert des Zeitraums "A" ab. Dieser Spannungsverlauf wird in der Auswerteeinrichtung bzw. dem Mikroprozessor 3 ausgewertet, die bzw. der dann anhand hinterlegter Parameter eine Tastenbetätigung detektiert.

Für diesen Fall wird das Ansteuersignal Ua während der durch die Auswerteeinrichtung bzw. den Mikroprozessor 3 erfassten Betätigung mit dem Signalzustand "Z" erzeugt, so dass das Beaufschlagen der Auswerteelektrode 1a mit dem Referenzpotential Uref während der ermittelten Betätigung unterdrückt wird, d.h. die Zeitabschnittswiederholdauer Tref wird mindestens so groß wie die ermittelte Betätigungsdauer gewählt. Auf diese Weise kann einfach und zuverlässig eine länger dauernde Betätigung detektiert werden, da kein Rücksetzen der Spannung an der Auswerteelektrode 1a erfolgt.

In einem Zeitraum "C" weist die abgetastete Spannung einen Verlauf auf, der wieder einem nicht betätigten Zustand entspricht. Es erfolgt nun ein Beaufschlagen der Auswerteelektrode 1a mit dem Referenzpotential Uref für eine vorgegebene Zeitabschnittsdauer bzw. Rücksetzzeitdauer Tp=Tres, um erneut einen definierten Anfangszustand herzustellen. Die Rücksetzdauer Tres ist hierbei größer als die Dauer Tp der Zeitabschnitte Za im Zeitraum "A". Nach dem Rücksetzen wird wie im zuvor beschriebenen Zeitraum "A" verfahren.

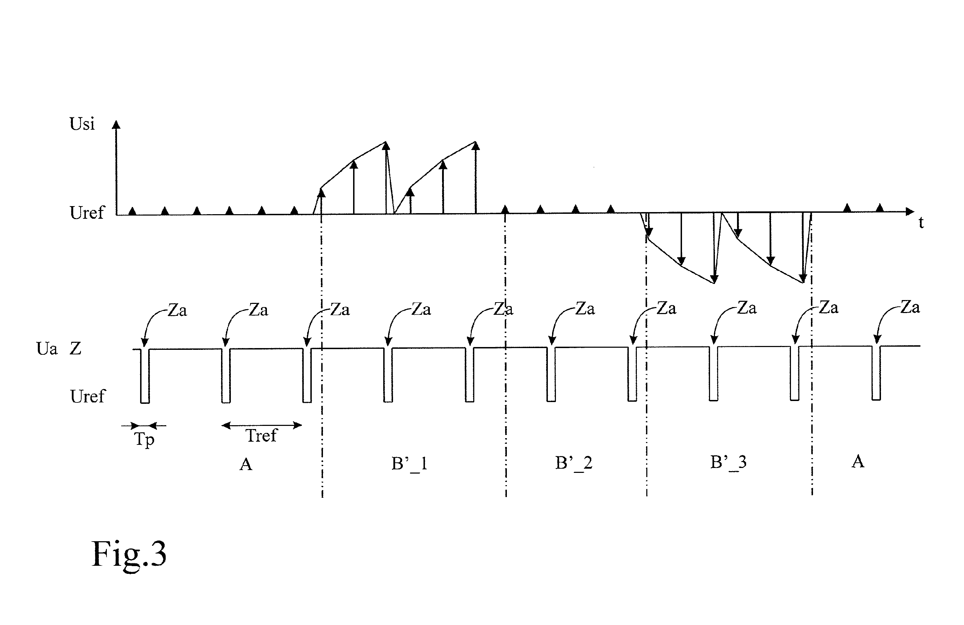

Fig. 3 zeigt einen zeitlichen Verlauf von Signalen der in Fig. 1 gezeigten Schaltung gemäß einer weiteren Ausführungsform, bei der die Auswerteelektrode 1a betätigungsunabhängig periodisch referenziert wird, d.h. die Zeitabschnittswiederholdauer Tref ist konstant. Um dennoch eine Dauerbetätigung des Sensors 1 detektieren zu können, wird die abgetastete Spannung Usi in der Auswerteeinrichtung 3 integriert, wobei die integrierte Spannung schließlich den Betätigungszustand abbildet und ausgewertet wird.

In einem Zeitraum B'_1 erfolgt ein Druckanstieg am Sensor 1 aufgrund einer beginnenden Betätigung. In einem Zeitraum B'_2 bleibt der Druck am Sensor 1 in etwa konstant. In einem Zeitraum B'_3 endet die Betätigung. Das Integral der abgetasteten Spannung Usi entspricht im Wesentlichen dem in Fig. 2 gezeigten Verlauf der abgetasteten Spannung Usi, so dass eine länger dauernde Betätigung detektiert werden kann, obwohl ein betätigungsunabhängiges, periodisches Rücksetzen der Spannung an der Auswerteelektrode 1a erfolgt.

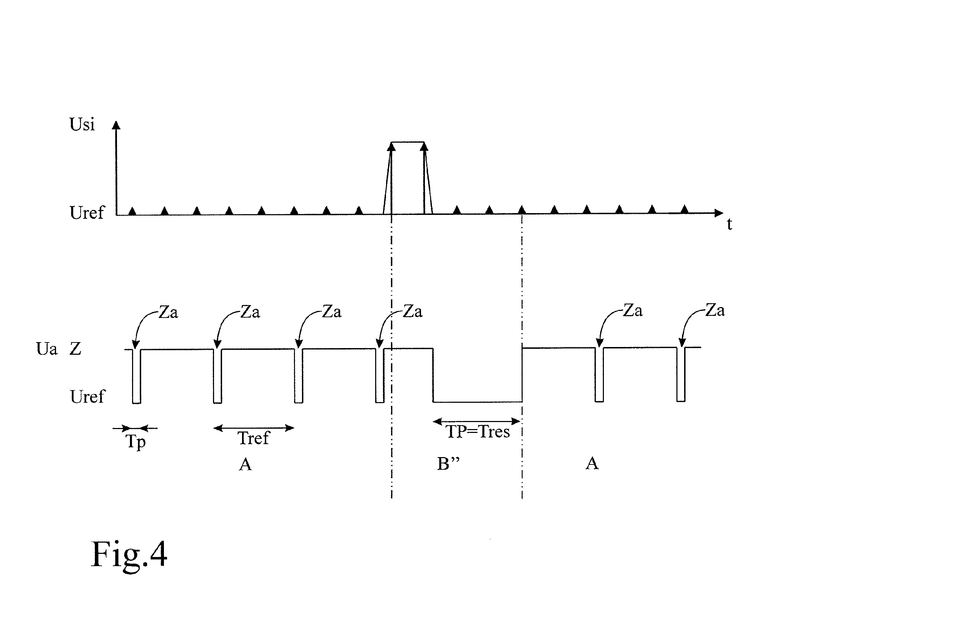

Fig. 4 zeigt einen zeitlichen Verlauf von Signalen der in Fig. 1 gezeigten Schaltung für den Fall eines transienten Störimpulses.

Der Spannungsverlauf der abgetasteten Spannung Usi entspricht hinsichtlich der Anstiegsgeschwindigkeit, Dauer, Amplitude etc. nicht dem Verlauf einer typischen Tastenbetätigung, so dass auf einen transienten Störimpuls geschlossen werden kann.

In Folge wird im Zeitraum B" die Auswerteelektrode 1a mit dem Referenzpotential Uref für die Zeitabschnittsdauer bzw. Rücksetzzeitdauer Tp=Tres beaufschlagt, um den Störimpuls zuverlässig zu unterdrücken.

Anschließend wird der Betrieb wie oben bezüglich des Zeitraums "A" beschrieben fortgesetzt.

Die gezeigten Ausführungsformen ermöglichen eine zuverlässige und störsichere Auswertung des piezokeramischen Sensors, insbesondere für den Fall einer länger andauernden Betätigung.

## Patentansprüche

1. Verfahren zum Betreiben eines piezokeramischen Sensors (1) mit einer Auswerteelektrode (1a), bei dem ein von dem piezokeramischen Sensor (1) an der Auswerteelektrode (1a) erzeugtes elektrisches Signal (Us) zum Bestimmen eines Betätigungszustandes des piezokeramischen Sensors (1) ausgewertet wird,
**gekennzeichnet durch** die Schritte:
- Beaufschlagen der Auswerteelektrode (1a) mit einem vorgegebenen Referenzpotential (Uref) während wiederkehrender Zeitabschnitte (Za).

2. Verfahren nach Anspruch 1, **dadurch gekennzeichnet, dass**
- die Zeitabschnitte (Za) jeweils eine Zeitabschnittsdauer (Tp) aufweisen und aufeinanderfolgende Zeitabschnitte (Za) um eine Zeitabschnittswiederholdauer (Tref) zeitlich beabstandet sind, wobei die Zeitabschnittsdauer (Tp) konstant oder variabel gewählt wird und/oder Zeitabschnittswiederholdauer (Tref) konstant oder variabel gewählt wird.

3. Verfahren nach Anspruch 2, **gekennzeichnet durch** die Schritte:
- Messen eines Spannungsverlaufs an der Auswerteelektrode (1 a),
- Auswerten des gemessenen Spannungsverlaufs, um gegebenenfalls einen Störimpuls zu ermitteln, und
- Beaufschlagen der Auswerteelektrode (1a) mit dem Referenzpotential (Uref) für eine Zeitabschnittsdauer (Tp=Tres), die insbesondere größer als eine mittlere Zeitabschnittsdauer gewählt ist, wenn der Störimpuls ermittelt worden ist.

4. Verfahren nach Anspruch 2 oder 3, **gekennzeichnet durch** die Schritte:
- Messen eines Spannungsverlaufs an der Auswerteelektrode (1 a), und
- Auswerten des gemessenen Spannungsverlaufs, um gegebenenfalls eine Betätigung des piezokeramischen Sensors (1) zu ermitteln, wobei die Zeitabschnittswiederholdauer (Tref) für den Fall der gegebenenfalls ermittelten Betätigung mindestens so groß wie eine ermittelte Betätigungsdauer gewählt wird, so dass die Auswerteelektrode (1a) während der gegebenenfalls ermittelten Betätigung nicht mit dem Referenzpotential (Uref) beaufschlagt wird.

5. Verfahren nach Anspruch 2 oder 3, **gekennzeichnet durch** die Schritte:
- Wählen einer konstanten Zeitabschnittswiederholdauer (Tref),
- Messen eines Spannungsverlaufs an der Auswerteelektrode (1a),
- Integrieren des gemessenen Spannungsverlaufs und
- Auswerten des integrierten Spannungsverlaufs zum Bestimmen eines Betätigungszustands des piezokeramischen Sensors (1).

6. Schaltung zur Durchführung des Verfahrens nach einem der Ansprüche 1 bis 5,
**gekennzeichnet durch**:
- Mittel (3, 4, 5) zum Beaufschlagen der Auswerteelektrode (1a) des piezokeramischen Sensors (1) mit dem vorgegebenen Referenzpotential (Uref) während der wiederkehrenden Zeitabschnitte (Za).

7. Schaltung nach Anspruch 6, **gekennzeichnet durch**
- eine Referenzspannungsquelle (4) zum Erzeugen des Referenzpotentials (Uref).

8. Schaltung nach Anspruch 6 oder 7, **dadurch gekennzeichnet, dass**
- das Referenzpotential ein Massepotential ist oder ein Potential zwischen dem Massepotential und einer Versorgungsspannung der Schaltung.

9. Schaltung nach einem der Ansprüche 6 bis 8, **gekennzeichnet durch**
- ein ansteuerbares Schaltmittel (5), das mit einem Anschluss mit dem Referenzpotential (Uref) beaufschlagt ist, das mit einem anderen Anschluss mit der Auswerteelektrode (1a) verbunden ist und das die Auswerteelektrode (1a) in Abhängigkeit von einem Ansteuersignal (Ua) mit dem Referenzpotential (Uref) verbindet oder von diesem trennt, und
- eine Steuereinrichtung (3) zur Erzeugung des Ansteuersignals (Ua).

10. Schaltung nach einem der Ansprüche 6 bis 9, **gekennzeichnet durch**
- einen Impedanzwandler (2) mit einem hochohmigen Eingang und einem niederohmigen Ausgang, wobei der Impedanzwandler (2) das an der Auswerteelektrode (1a) erzeugte elektrisches Signal (Us) an seinem Eingang empfängt und an seinem Ausgang ausgibt, und
- eine Auswerteeinrichtung (3), die das am Ausgang des Impedanzwandlers ausgegebene Signal auswertet.

11. Schaltung nach einem der Ansprüche 7 bis 10, **gekennzeichnet durch**
- einen Mikroprozessor, wobei die Referenzspannungsquelle und/oder der Impedanzwandler in den Mikroprozessor integriert ist/sind.
